# EUROPEAN PATENT APPLICATION

(11) **EP 4 456 137 A1**
(43) Date of publication of application: **30.10.2024**
(21) Application number: 24153815.6
(22) Date of filing: 25.01.2024
(51) Int. Cl.: H01L 27/02, H01L 29/87

(54) **ELECTROSTATIC DISCHARGE DEVICES**

(30) Priority: 27.04.2023 US 202318308322
(71) Applicant: GLOBALFOUNDRIES Singapore Pte. Ltd., Singapore 738406 (SG)
(72) Inventor: HWANG, Kyong Jin, Singapore 738406 (SG); ZENG, Jie, Singapore 738406 (SG); AJAY, Ajay, 560045 Bangalore (IN)
(74) Representative: Lambacher, Michael

(57) **Abstract**

The present disclosure relates to semiconductor structures and, more particularly, to high-voltage electrostatic discharge (ESD) devices and methods of manufacture. The structure includes a semiconductor material of a first dopant type; a first well having a second dopant type in the semiconductor material; a floating well in the first well, the second well having the first dopant type; and a diffusion region of the second dopant type adjacent to the floating well and in electrical contact to the first well.

## Description

### FIELD OF THE INVENTION

The present disclosure relates to semiconductor structures and, more particularly, to electrostatic discharge devices and methods of manufacture.

### BACKGROUND

Electrostatic discharge (ESD) devices protect integrated circuits from the sudden flow of electricity caused by, for example, contact, electrical shorts or dielectric breakdown. ESD devices can thus protect integrated circuits from failure. ESD devices come in a variety of different structures such as resistors, fuses, etc.

ESD devices need to be in the ESD safe window with high current performance and high holding voltage (Vh) for high voltage applications. For example, the holding voltage needs to be higher than the operating voltage or the device will not turn OFF after turning ON against ESD stress and discharge ESD stress during normal operation. In such a situation, the current will discharge, and the integrated circuit can become damaged.

Meeting both high current performance and high holding voltage for high voltage ESD demand is very challenging, though. For example, there is typically a tradeoff between high current performance and high holding voltage. That is, conventional devices typically provide either high current performance or high holding voltage. Illustratively, a high voltage PNP can provide a relatively high holding voltage control but not a high current performance, whereas a low voltage/high voltage silicon-controlled rectifier (SCR) can provide relatively high current performance but not a high holding voltage control.

### SUMMARY

In an aspect of the disclosure, a structure comprises: a semiconductor material of a first dopant type; a first well comprising a second dopant type in the semiconductor material; a floating well in the first well, the floating well comprising the first dopant type; and a diffusion region of the second dopant type adjacent to the floating well and in electrical contact to the first well.

Additional features of the structure are set forth in dependent claims 2 to 10.

In an aspect of the disclosure, a structure comprises: a vertical NPN device in a substrate material, the vertical NPN device comprising an internal resistor within a p+ well of the NPN device; and a vertical PNPN device in the substrate and electrically connecting to the NPN device through a buried layer of semiconductor layer.

Additional features of the structure are set forth in dependent claims 12 to 14.

In an aspect of the disclosure, a method comprises: forming a first well comprising a second dopant type in a semiconductor material comprising a first dopant type; forming a floating well in the first well, the floating well comprising the first dopant type; and forming a diffusion region of the second dopant type adjacent to the floating well and in electrical contact to the first well.

### BRIEF DESCRIPTION OF THE DRAWINGS

The present disclosure is described in the detailed description which follows, in reference to the noted plurality of drawings by way of non-limiting examples of exemplary embodiments of the present disclosure.
FIG. 1 shows an electrostatic discharge device (ESD) device and respective fabrication processes in accordance with aspects of the present disclosure.
FIG. 2 shows an ESD device and respective fabrication processes in accordance with additional aspects of the present disclosure.
FIG. 3 shows an ESD device in accordance with further aspects of the present disclosure.
FIG. 4 shows an ESD device in accordance with yet additional aspects of the present disclosure.
FIG. 5 shows an ESD device in accordance with further aspects of the present disclosure.

### DETAILED DESCRIPTION

The present disclosure relates to semiconductor structures and, more particularly, to electrostatic discharge devices (ESD) and methods of manufacture. More specifically, in exemplary embodiments, the ESD device(s) is a high-performance ESD device comprising a vertical silicon-controlled rectifier (SCR) combined with a vertical NPN device. In embodiments, an internal resistor is provided within a p-well of the NPN. Advantageously, the ESD device provides high current performance for high-voltage applications, with relatively high holding voltage for high-voltage applications while keeping high current performance. In addition, the ESD devices provide fast turn-on time with lower trigger voltage (e.g., reduce turn on voltage) while keeping a high DC breakdown voltage. Moreover, the ESD device provides significant chip area savings compared to a structure with an equivalent performance.

The ESD devices of the present disclosure can be manufactured in a number of ways using a number of different tools. In general, though, the methodologies and tools are used to form structures with dimensions in the micrometer and nanometer scale. The methodologies, i.e., technologies, employed to manufacture the ESD devices of the present disclosure have been adopted from integrated circuit (IC) technology. For example, the structures are built on wafers and are realized in films of material patterned by photolithographic processes on the top of a wafer. In particular, the fabrication of the ESD devices uses three basic building blocks: (i) deposition of thin films of material on a substrate, (ii) applying a patterned mask on top of the films by photolithographic imaging, and (iii) etching the films selectively to the mask.

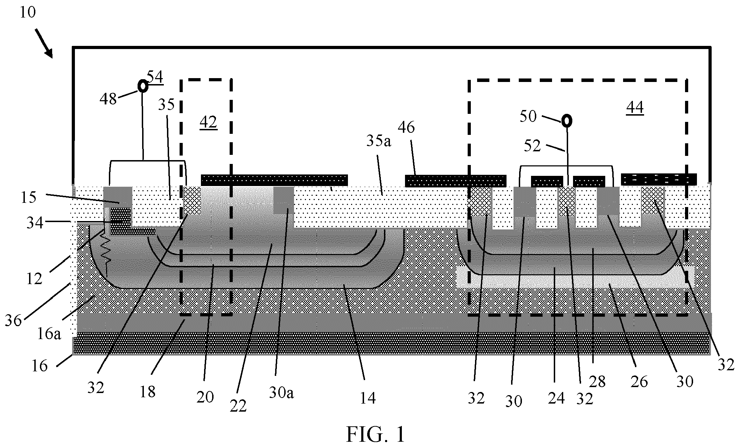

FIG. 1 shows an ESD device in accordance with aspects of the present disclosure. In particular, the ESD device 10 of FIG. 1 includes a resistor 12 formed within a p-well 14 (e.g., p-well resistor) and in electrical contact with a cathode 48. For example, the resistor 12 may be provided in the p-well 14 and biased by a p+ diffusion region 15. In this way, the resistor 12 is an internal p-active resistor of an NPN device which is part of an ESD device. In embodiments, the resistor 12 may have a resistance of, e.g., 10 kohm, which enables fast triggering and reduces turn on voltage. Also, significant footprint reduction of the device is achieved due to the fact that the resistor 12 is internally provided to the structure 10 (compared to the use of external resistors).

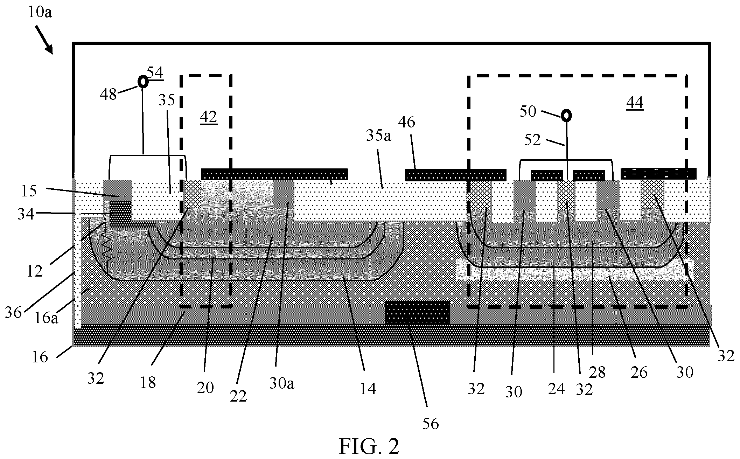

More specifically, the structure 10 comprises a semiconductor substrate 16. In embodiments, the semiconductor substrate 16 may be a p+ substrate composed of any suitable semiconductor material including, but not limited to, Si, SiGe, SiGeC, SiC, GaAs, InAs, InP, and other III/V or II/VI compound semiconductors. A n+ region 18 may be provided in the semiconductor substrate 16, with an n-epitaxial semiconductor layer 16a provided over the n+ region 18. In this way, the n+ region 18 may be a buried n+ region. In embodiments, the n+ buried region 18 may be e.g., continuous layer (as shown in FIG. 1) or discontinuous layer (as shown in FIG. 2).

In embodiments, the n+ buried region 18 may be formed by introducing a n+ dopant by, for example, using an ion implantation process. In the ion implantation process, the n+ dopant type may be introduced while using a patterned implantation mask to define selected areas exposed for the implantation. The n-type dopants used in the n+ buried region 18 may include, e.g., Arsenic (As), Phosphorus (P) and Antimony (Sb), among other suitable examples, at a dopant dose concentration of approximately 1E18 cm⁻³ to 5E20 cm⁻³. The implantation mask may include a layer of a light-sensitive material, such as an organic photoresist, applied by a spin coating process, pre-baked, exposed to light projected through a photomask, baked after exposure, and developed with a chemical developer. The implantation mask has a thickness and stopping power sufficient to block masked areas against receiving a dose of the implanted ions.

FIG. 1 further shows the p-well 14 formed in the semiconductor substrate 16, which is remotely positioned from the n+ buried region 18 (NBL). In embodiments, the p-well 14 is a high-voltage p-well may be formed using p-type dopants, e.g., Boron (B). As with any of the well regions and diffusion regions described herein, the high-voltage p-well 14 may be formed by an ion implantation processes as described herein by deposition of an implantation mask (similar to the mask described above), followed by a patterning process to form an opening and, thereafter, an ion implantation process of certain dopant type, e.g., p-type dopant for the p-wells. The concentration of dopant for the p-well 14 may be approximately 4E16 cm⁻³ to 2E18 cm⁻³.

A p-well 20 may be formed in the p-well 14. In embodiments, the p-well 20 may be a p-type high-voltage double diffusion drain (HVPDDD), formed using an ion implantation process with an appropriate implantation mask as already described herein such that no further explanation is required for a complete understanding of the present disclosure. In embodiments, the p-well 20 may have a dopant dose concentration of, e.g., approximately 1E16 cm⁻³ to 4E18 cm⁻³. A p-well 22 may be formed in the p-well 20. Again, the p-well 22 may be formed by conventional ion implantation processes with appropriate dopant types at a dopant dose concentration of, e.g., approximately 1E17 cm⁻³ to 1E19 cm⁻³.

An n-well 24 may be formed in the n-epitaxial semiconductor layer 16a, remote from the p-wells 14, 20, 22. In other words, the n-well 24 may be separated from the p-wells 14, 20, 22 by n-epitaxial semiconductor layer 16a. In embodiments, the n-well 24 may be an n-type high-voltage double diffusion drain (HVNDDD) formed by using an ion implantation process with an appropriate implantation mask as already described herein. In embodiments, the n-well 24 may have a lower dopant dose concentration to control breakdown voltage, e.g., of approximately 5E15 cm⁻³ to 4E18 cm⁻³.

A p-buried layer 26 may be formed below the n-well 24. In embodiments, the p-buried layer 26 make be remotely positioned from the n+ buried region 18. The p-buried layer 26 may be formed using an ion implantation process with a dopant dose concentration of, e.g., approximately 1E16 cm⁻³ to 1E19 cm⁻³. An-well 28 may be formed in the n-well 24 using conventional ion implantation processes with appropriate dopant types at a dopant dose concentration of, e.g., approximately 1E17 cm⁻³ to 1E19 cm⁻³.

FIG. 1 further shows p+ doped diffusion regions 30, 30a and n+ doped diffusion regions 32 formed in the p-well 22 and the n-well 28. The diffusion regions 30, 30a, 32 may be formed using respective p-type dopants and n-type dopants. A floating n-well 34 may be formed in and/or overlapping with the p-well 14. In embodiments, the floating n-well 34 may also partially overlap or abut to the p-wells 20, 22. The p+ diffusion region 15 may be formed in electrical contact with the n-well 34 and the cathode 48. In this configuration, resistor 12 is formed internally within the p-well 14, eliminating the need for an external resistor and thereby significantly reducing the footprint of the structure 10.

The p+ doped diffusion regions 30, 30a, 15, and n+ doped diffusion region 32 may be doped at a dopant concentration, e.g., 5E19 cm⁻³ to 5E21 cm⁻³. The n-well 34 may be doped at a dopant concentration, e.g., 1E17 cm⁻³ to 1E19 cm⁻³. The n-well 34 and the n-well 28 may be formed in the same implant process. The structure 10 may undergo a thermal process (e.g., rapid thermal process) for dopant activation and diffusion.

Still referring to FIG. 1, shallow trench isolation structures 35 may be formed in the wells 14, 20, 22, 24, 28 with the shallow trench isolation structure 35a spanning between the wells 14, 24. The shallow trench isolation structures 35, 35a may be used to isolate the p-wells from the n-wells, in addition to isolating the diffusion regions 15, 30, 32. In embodiments, the lateral dimension of the shallow trench isolation structures 35a spanning between the wells 14, 24 may be adjusted to provide a high DC breakdown voltage and prevention of a lateral SCR. Also, in embodiments, the shallow trench isolation structures 35, 35a can be replaced by LOCOS (LOCal Oxidation of Silicon). Deep trench isolation structures 36 may also be formed at the edges of the cathode region 42 for further isolation, which punches through the n+ buried region 18.

The shallow trench isolation structures 35, 35a and deep trench isolation structures 36 can be formed by conventional lithography, etching and deposition methods known to those of skill in the art. By way of example, a resist formed over the semiconductor substrate 16 is exposed to energy (light) to form a pattern (opening). An etching process with a selective chemistry, e.g., reactive ion etching (RIE), will be used to form one or more trenches in the semiconductor substrate 16 through the openings of the resist. Following the resist removal by a conventional oxygen ashing process or other known stripants, insulator material, e.g., oxide, can be deposited in the trenches by any conventional deposition processes, e.g., chemical vapor deposition (CVD) process, to form the shallow trench isolation structures 35, 35a and deep trench isolation structure 36. Any residual insulator material on the surface of the semiconductor substrate 16 can be removed by conventional chemical mechanical polishing (CMP) processes.

As further shown in FIG. 1, the cathode 48 connects to a vertical NPN device 42 and an anode 50 connects to a vertical PNPN SCR device 44. That is, the vertical NPN region 42 may be on a cathode side of the device; whereas the vertical PNPN SCR 44 may be on the anode side 50 of the device. It should be recognized that the vertical NPN device 42 comprises a combination of regions 32, 22, 20, 16a; whereas the vertical PNPN SCR device 44 comprises the combination of regions 30, 28, 24, 26, 16a. Moreover, both of the devices 42, 44 will electrically connect together through the n+ buried region 18.

In embodiments, the NPN device 42 and the PNPN SCR device 44 are separated by the shallow trench isolation structure (or LOCOS) 35a. In further embodiments, the space between the shallow trench isolation structure 35a may be large, e.g., approximately 4 to 10 µm or larger, to provide a high DC breakdown voltage and prevention of a lateral SCR. In embodiments, the lateral SCR can lead to high density of current flow due to a narrow current path. And, by using the p-buried layer 26, the PNPN SCR device 44 can have a current performance of approximately 80 mA/um, which is a relatively high current to provide improved performance and high holding voltage (Vh) compared to a conventional high voltage NPN SCR.

On the anode side of the device, a resistive path (e.g., resistor) may be formed in the n-epitaxial semiconductor layer 16a, between the n+ buried region 18 and the p-buried layer 26. In addition, on the anode side of the device, a first diode and second diode may be formed in series. The first diode may be formed by the p+ buried layer 26 and the n-epitaxial semiconductor layer 16a; whereas the second diode may be formed by the n+ doped diffusion region 32 and the p+ doped diffusion region 30 in the n-well 28. On the cathode side, a diode may be formed by the p-well 14 and the n-epitaxial semiconductor layer 16a, between the n+ doped diffusion region 32 in the doped diffusion region 15. The first diode and second diode may be parallel to the diode on the cathode side of the structure. Also, the resistor 12 may be in series with the diode on the cathode side of the structure.

Contacts 52 of the cathode 48 and anode 50 are composed of metal contacts. Prior to forming the contacts 52 to the cathode 48 and anode 50, a silicide block layer 46 (e.g., SiN) may be formed over portions of the structure including, e.g., completely blocking the p+ doped diffusion region 30a. In embodiments, the mask prevents the p+ doped region 30a from being silicide and will prevent the formation of a lateral SCR for high voltage (Vh) control. The non-silicided diffusion region 30a will be a floating p-type region between the cathode 48 and the shallow trench isolation structure 35a. The dimensions (e.g., width) of the floating p-type region can be adjusted for preventing a lateral SCR making current flow in a vertical direction through the PNPN and NPN, and increase holding voltage.

A silicide process may be performed to form silicide on the remaining active diffusion regions 15, 30, 32. As should be understood by those of skill in the art, the silicide process begins with deposition of a thin transition metal layer, e.g., nickel, cobalt or titanium, over fully formed and patterned devices (e.g., diffusion regions). After deposition of the material, the structure is heated allowing the transition metal to react with exposed silicon (or other semiconductor material as described herein) in the active regions of the device forming a low-resistance transition metal silicide. Following the reaction, any remaining transition metal is removed by chemical etching, leaving silicide contacts in the active regions of the device.

Following the silicide process, an insulator material 54 may be formed over the structure using a conventional deposition process of oxide material, e.g., chemical vapor deposition (CVD) processes. The insulator material 54 undergoes a conventional etching (RIE) process to form openings exposing the silicide regions. Thereafter, contact metal(s), e.g., aluminum, tungsten, etc., may be deposited within openings of the insulator material 54 to form the contacts 52 for the cathode 48 and the anode 50. In embodiments, the contacts 52 of the cathode 48 may be in direct contact with the doped diffusion regions 15, 32 and the contacts 54 of the anode 50 may be in direct contact with p+ doped diffusion regions 30 in the n-well 28.

FIG. 2 shows an ESD device in accordance with further aspects of the present disclosure. In the ESD device 10a of FIG.2, the n+ buried region 18 is a discontinuous layer with an optional p+ buried region 56 separating different sections of the n+ buried regions 18 within the semiconductor substrate 16. In embodiments, splitting of the n+ buried region 18 with the p+ buried region 56 (e.g., p-isolation regions) enables high holding voltage. The remaining features are similar to the structure 10 of FIG. 1.

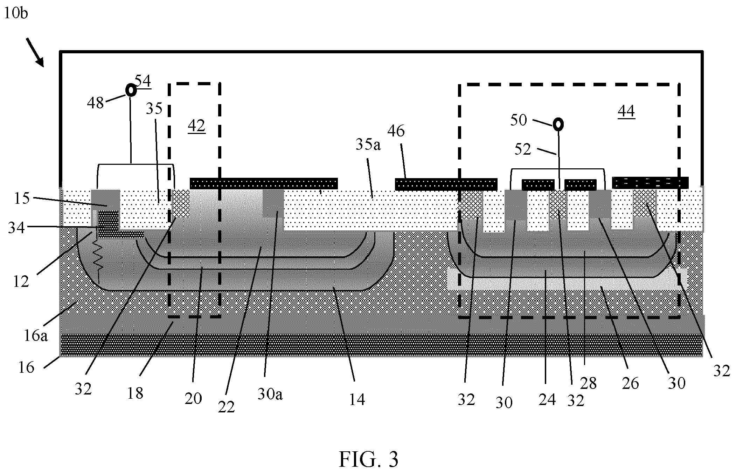

FIG. 3 shows an ESD device in accordance with further aspects of the present disclosure. In the ESD device 10c of FIG. 3, the deep trench isolation structures at the cathode 48 may be eliminated. The remaining features may be similar to the structures 10 and 10a shown and described with respect to FIG. 1 or FIG. 2.

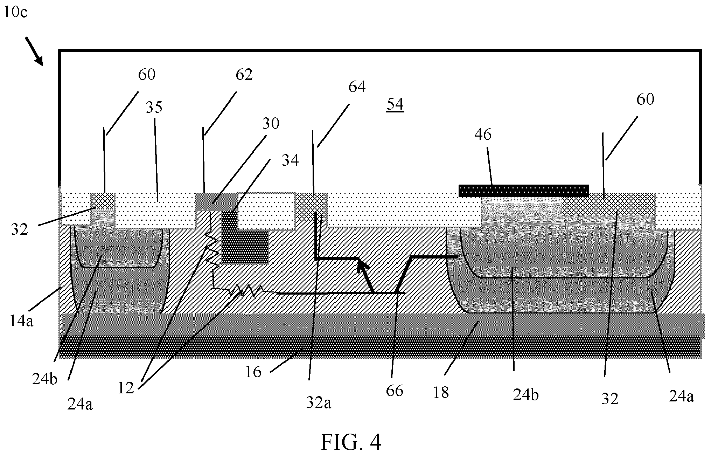

FIG. 4 shows an ESD device in accordance with further aspects of the present disclosure. In this embodiment, the structure 10c comprises a high voltage ESD NPN/MOSFET and ESD SCR. For example, in the structure 10c, n-wells 24a, 24b are formed in a high voltage p-well 14a. The n+ doped diffusion regions 32 may be formed in the n-wells 24a, 24b and electrically connected to a collector 60. A silicide block layer 46 (e.g., SiN) may be formed over portions of the structure including, e.g., over the n-well 24a on a collector side of the device. A p+ diffusion region 30 may be provided in the high voltage p-well 14a and electrically connected to a base 62. In embodiments, the resistor 12 may be formed in the high voltage p-well 14a connecting to the p+ diffusion region 30. A floating n-well 34 may be formed in and/or overlapping with the high voltage p-well 14a and the p+ diffusion region 30. A diode 66 may be formed in series with the resistor 12, which is formed in the high voltage p-well 14a, between the n+ diffusion region 32a and the n-wells 24a, 24b. The n+ diffusion region 32a may be electrically connected to the emitter 64.

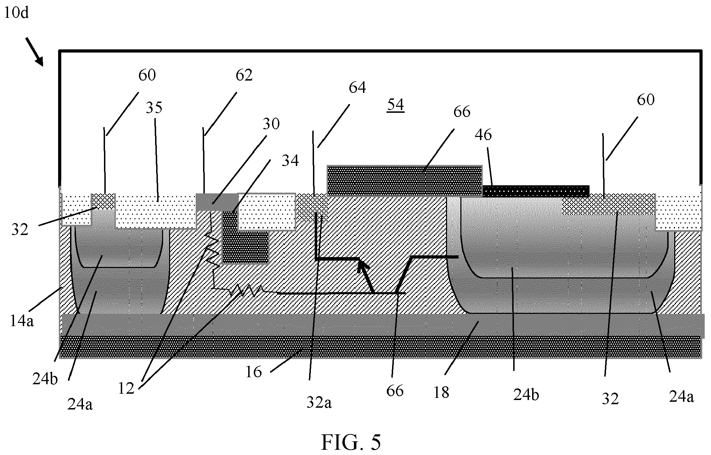

FIG. 5 shows another high voltage ESD NPN/MOSFET and ESD SCR device. In this structure 10d, the shallow trench isolation structure between the n+ diffusion region 32a and the n-wells 24a, 24b may be replaced with a polysilicon material 66 on a surface of the high voltage p-well 14a. The remaining features are similar to the structure 10c of FIG. 4.

The ESD devices can be utilized in system on chip (SoC) technology. The SoC is an integrated circuit (also known as a "chip") that integrates all components of an electronic system on a single chip or substrate. As the components are integrated on a single substrate, SoCs consume much less power and take up much less area than multichip designs with equivalent functionality. Because of this, SoCs are becoming the dominant force in the mobile computing (such as in Smartphones) and edge computing markets. SoC is also used in embedded systems and the Internet of Things.

The method(s) as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure comprising:
a semiconductor material of a first dopant type;
a first well comprising a second dopant type in the semiconductor material;
a floating well in the first well, the floating well comprising the first dopant type; and
a diffusion region of the second dopant type adjacent to the floating well and in electrical contact to the first well.

2. The structure of claim 1, wherein the first dopant type is an n+ dopant and the second dopant type is a p+ dopant.

3. The structure of claim 1 or claim 2, wherein the first well comprises an internal well resistance electrically connecting to a cathode and the diffusion region adjacent to the floating well.

4. The structure of one of claims 1 to 3, further comprising a n+ type buried layer below the first well, and, optionally, wherein the buried layer is a discontinuous buried layer split by regions of an opposite dopant type to the buried layer.

5. The structure of claim 3 or claim 4, further comprising an n+ diffusion region within the first well, the n+ diffusion region and the first diffusion region connecting to the cathode.

6. The structure of claim 5, further comprising a shallow trench isolation structure between the n+ diffusion region and the first diffusion region, wherein the n+ diffusion region, the first well and the semiconductor material form a vertical NPN device.

7. The structure of claim 5 or claim 6, further comprising a diode in series with the internal well resistance, the diode forming between the n+ diffusion region and the first well.

8. The structure of one of claims 4 to 7, further comprising a PNPN device connecting to an anode and electrically connecting to the first well through the n+ type buried layer, and, optionally, wherein the PNPN device is a vertical silicon controlled rectifier (SCR) PNPN device.

9. The structure of claim 2, wherein the first well comprises an internal resistance electrically connecting to the diffusion region adjacent to the floating well and a base, with a second diffusion region in the first well connecting to an emitter and a third diffusion region connecting to a collector.

10. The structure of claim 9, further comprising a shallow trench isolation structure between the emitter and an n+ well in which is located the third diffusion region connecting to the collector, or a polysilicon material between the emitter and an n+ well in which is located the third diffusion region connecting to the collector.

11. A structure comprising:
a vertical NPN device in a substrate material, the vertical NPN device comprising an internal resistor within a p+ well of the NPN device; and
a vertical PNPN device in the substrate and electrically connecting to the NPN device through a buried layer of semiconductor layer.

12. The structure of claim 11, wherein the vertical NPN device comprises a p+ diffusion region electrically connecting between the internal resistor within the p+ well and a cathode and the vertical PNPN device is electrically connected to an anode, and, optionally, wherein the vertical NPN device comprises an n-well within the p+ well and which is adjacent to the p+ diffusion region.

13. The structure of claim 11 or claim 12, wherein the buried layer of semiconductor layer comprises a discontinuous layer of n+ dopant type separated by a p+ dopant type.

14. The structure of claim 12 or claim 13, further comprising a shallow trench isolation structure separating wells connecting to the cathode and the anode, and/or further comprising a floating p+ diffusion region within the p+ well and a silicide blocking layer over the floating p+ diffusion region.

15. A method comprises:
forming a first well comprising a second dopant type in a semiconductor material comprising a first dopant type;
forming a floating well in the first well, the second well comprising the first dopant type; and
forming a diffusion region of the second dopant type adjacent to the floating well and in electrical contact to the first well.
